# EUROPÄISCHE PATENTSCHRIFT

(11) **EP 2 715 373 B1**
(45) Veröffentlichungstag und Bekanntmachung des Hinweises auf die Patenterteilung: **06.06.2018**
(21) Anmeldenummer: 12726735.9
(22) Anmeldetag: 11.05.2012
(51) Int. Cl.: G01R 1/067, G01D 5/02

(54) **FEDERKONTAKTSTIFTANORDNUNG**
SPRING CONTACT PIN ARRANGEMENT
ENSEMBLE POINTE DE CONTACT À RESSORT

(30) Priorität: 27.05.2011 DE 102011102791
(43) Veröffentlichungstag der Anmeldung: 09.04.2014
(73) Patentinhaber: Feinmetall GmbH, 71083 Herrenberg (DE)
(72) Erfinder: BURGOLD, Jörg, 71083 Herrenberg (DE)
(74) Vertreter: Clarenbach, Carl-Philipp
(86) Internationale Anmeldenummer: PCT/EP2012/002023
(87) Internationale Veröffentlichungsnummer: WO 2012/163472

(56) Entgegenhaltungen:
- DD-A7- 286 958
- DE-A1- 19 541 287
- DE-B3-102006 025 850
- DE-U1- 20 008 214
- DE-U1- 20 102 558
- DE-U1-202006 002 361
- US-A- 4 884 024

## Beschreibung

Die Erfindung betrifft eine Federkontaktstiftanordnung mit einem Federkontaktstift, der ein Stiftgehäuse aufweist, in dem ein Kontaktelement längsverschieblich gelagert und von einer entgegen einer Verschieberichtung wirkenden Federeinrichtung kraftbeaufschlagt ist, wobei das Kontaktelement mit mindestens einer ersten Schnittstelle der Federkontaktstiftanordnung in elektrischer Verbindung steht und mit einem Kontaktbereich zur elektrischen Kontaktierung eines elektrischen Prüflings aus dem Stiftgehäuse herausragt.

Eine Federkontaktstiftanordnung der eingangs genannten Art ist bekannt. Ein Federkontaktstift der Federkontaktstiftanordnung dient zur elektrischen Berührungskontaktierung eines elektrischen Prüflings, um dessen Funktionsfähigkeit zu prüfen. Für einen Anwesenheitstest eines elektrischen Prüflings kann eine Ja/Nein-Aussage durch Abfrage eines elektrischen Kontakts des Federkontaktstifts ausreichen. Wird als Federkontaktstift ein Schaltstift verwendet, der im Zuge dieser Anmeldung ebenfalls als Federkontaktstift angesehen wird, so ist eine Ja/Nein-Aussage über die Anwesenheit beziehungsweise Position des Prüflings in einem vorgegebenen Prüfbereich (Schaltbereich des Schaltstifts) möglich. Dabei muss die Lage des Schaltstifts relativ zur Lage des Prüflings durch Justierarbeiten eingestellt werden. Die Genauigkeit einer derartigen Positionsbestimmung mittels eines Federkontaktstifts ist nicht sehr hoch (circa +/- 0,2 mm). Diese Methode erlaubt keine quantitative Aussage über die Absolutlage des Prüflings, sondern nur über die Lage innerhalb oder außerhalb eines mechanisch vorgegebenen Toleranzbereichs. Hinzu kommen prinzipbedingte Messfehler aufgrund von mechanischen Toleranzen, die unmittelbar in das Messergebnis einfließen und sich ungünstig addieren können. Das so entstehende Prüfergebnis hat eine begrenzte Repräsentanz. Der übliche Federkontaktstift (also nicht Schaltstift), der eine elektrische Berührungskontaktierung zum Prüfling vornimmt, jedoch keine elektrische Schaltstrecke aufweist, ist lediglich für eine elektrische Prüfung einsetzbar und für eine Anwesenheitsprüfung nur in Bezug auf die erwähnte Grobaussage (Prüfling anwesend oder Prüfling nicht anwesend) brauchbar, wobei ein elektrischer Fehler (zum Beispiel kein elektrisches Potential) keine Aussage darüber zulässt, ob der Prüfling defekt ist oder ob er nicht anwesend ist.

Das Dokument DE 10 2006 025 850 B3 offenbart einen Prüfstift, der alle Merkmale des Oberbegriffs des Anspruchs 1 aufweist.

Der Erfindung liegt daher die Aufgabe zugrunde, eine Federkontaktstiftanordnung der eingangs genannten Art zu schaffen, die flexibel einsetzbar ist und mit der eine genauere und umfangreichere Prüfung eines elektrischen Prüflings möglich ist.
Diese Aufgabe wird erfindungsgemäß unter Berücksichtigung der eingangs genannten Federkontaktstiftanordnung dadurch gelöst, dass die Federkontaktstiftanordnung einen Positionssensor aufweist, wobei das Kontaktelement zur Übertragung seines Hubs mit einem verlagerbaren Sensorelement des die Hubposition des Kontaktelements erfassenden Positionssensors in Verbindung steht. Dieses erfindungsgemäße Funktionsprinzip ermöglicht es, einen Prüfling sowohl elektrisch zu kontaktieren als auch gleichzeitig über den Positionssensor die genaue Position des Prüflings zu bestimmen. Diese Positionserfassung erfolgt über den Hub (Arbeitshub) des Kontaktelements. Mithin stellt das Kontaktelement des Federkontaktstifts den elektrischen Kontakt mit dem Prüfling her und dient gleichzeitig als "Tastelement" im Hinblick auf seinen gegen die Federeinrichtung bei einem Prüfvorgang erfolgenden Hub, der zu einer entsprechenden Verlagerung des Sensorelements des Positionssensors führt, sodass der Positionssensor im Sinne eines Längenmesssystems die Position des Prüflings ermitteln kann. Insofern handelt es sich bei dem erfindungsgemäßen Prinzip um eine Doppelfunktion, in dem ein Federkontaktstift in Kombination mit den erfindungsgemäßen Merkmalen des Positionssensors in der Lage ist, zwei Messungen gleichzeitig durchzuführen, nämlich die elektrische Messung und ferner die Positionsmessung.

Nach einer Weiterbildung der Erfindung ist vorgesehen, dass der Positionssensor im Stiftgehäuse des Federkontaktstifts untergebracht ist oder als zum Federkontaktstift separater Positionssensor, insbesondere Positionssensorstift, insbesondere mit einem stiftförmigen Sensorgehäuse, ausgebildet ist. Eine besonders platzsparende Bauart ergibt sich, wenn der Positionssensor im Stiftgehäuse des Federkontaktstifts untergebracht ist, wobei diese Lösung weniger flexibel ist, als die Alternative, nämlich die Ausbildung des Positionssensors, insbesondere als Positionssensorstift, der separat zum Federkontaktstift ausgebildet ist. Federkontaktstift und Positionssensor, insbesondere Positionssensorstift, werden derart zueinander angeordnet, dass der Federkontaktstift seine Kontaktierfunktion und der Positionssensor seine Positionsmessfunktion durchführen kann, wobei eine mechanische Kopplung zwischen den beiden Einheiten vorgesehen ist, um den Hub des Kontaktelements des Federkontaktstifts auf das Sensorelement des Positionssensors zu übertragen. Die Ausbildung zweier separater Einheiten, insbesondere Stifte, die miteinander gekoppelt sind, erlaubt einen flexibleren Einsatz, da der Federkontaktstift auch ohne Positionssensor verwendet werden kann, und beim Ausfall einer der beiden Einheiten nur die defekte Einheit ersetzt werden muss. Die Querschnittsabmessungen von Federkontaktstift und Positionssensorstift können besonders klein ausgestaltet werden, sodass eine hohe Stiftdichte (Zahl der Stifte pro Flächeneinheit) positioniert werden können und somit eine Messung mit sehr kleinem Rastermaß (zum Beispiel hohe Kontaktdichte des Prüflings) ermöglicht ist. Bei Kombination von verschiedenen kommerziellen Federkontaktstiften mit dem Positionssensor ist Voraussetzung, dass die mechanische Kopplung ermöglicht werden kann und der Federkontaktstift-Kolbenhub den Messbereich des Sensors nicht überschreitet.

Ferner ist es vorteilhaft, wenn Federkontaktstift und Positionssensor, insbesondere Stiftgehäuse und Sensorgehäuse, in Hintereinanderanordnung oder in Nebeneinanderanordnung zueinander angeordnet sind. Die Hintereinanderanordnung erlaubt eine einfache Übertragung des Hubs des Kontaktelements des Federkontaktstifts auf das Sensorelement des Positionssensors und lässt insbesondere eine hohe Stiftdichte aufgrund der geringen Querschnittsabmessungen der Anordnung zu. Die Nebeneinanderanordnung verringert die Bautiefe der Einheit, erhöht jedoch das Maß der Querschnittsabmessung, sodass eine geringere Packungsdichte die Folge ist. Liegen die beiden Einheiten, insbesondere Stifte, in Nebeneinanderanordnung zueinander, so ist es erforderlich, mittels eines Seitenarms oder dergleichen das Kontaktelement mit dem Sensorelement mechanisch zu koppeln. Demzufolge sind bevorzugt entsprechende Schlitzausnehmungen in den Gehäusen der beiden Stifte vorgesehen, um die Armbewegung zu ermöglichen.

Nach einer vorteilhaften Weiterbildung der Erfindung ist eine Kupplungshülse vorgesehen, die mit einem Bereich zumindest einen Abschnitt des Federkontaktstifts und mit einem anderen Bereich zumindest einen Abschnitt des Positionssensors, insbesondere Positionssensorstifts, aufnimmt. Die Kupplungshülse kuppelt die beiden Einheiten, insbesondere Stifte, in Hintereinanderanordnung. Dabei kann insbesondere vorgesehen sein, dass ein Außengewinde des Federkontaktstifts in ein Innengewinde der Kupplungshülse eingeschraubt wird. Entsprechendes gilt für den Positionssensor beziehungsweise Positionssensorstift, d.h., dieser weist ebenfalls vorzugsweise ein Außengewinde auf, das in ein Innengewinde der Kupplungshülse eingeschraubt wird, wodurch die beiden Einheiten, insbesondere Stifte, über die Kupplungshülse in Hintereinanderanordnung zueinander gehalten werden und - in axialer Richtung gesehen - mittels einer entsprechenden Stößelanordnung der Hub des Kontaktelements des Federkontaktstifts auf das Sensorelement übertragen wird, sodass dieses - angetrieben durch das Kontaktelement - denselben Hub durchläuft und auf diese Art und Weise die Position des Prüflings - abgetastet durch das Kontaktelement - ermittelt werden kann.

Selbstverständlich ist es auch möglich, die beiden Einheiten, insbesondere Stifte, über andere Verbindungsarten als Innengewinde und Außengewinde an der Kupplungshülse zu halten. So sind auch Anschlagsstufen denkbar, Bajonettverschlüsse und so weiter.

Eine Weiterbildung der Erfindung sieht vor, dass die Kupplungshülse eine Montagehülse des Federkontaktstifts ist. Dies bedeutet, dass der Federkontaktstift mittels der Montagehülse an einer Prüfeinrichtung oder dergleichen gehalten wird. Sofern der Positionssensor, insbesondere der Positionssensorstift, mittels der Kupplungshülse an dem Federkontaktstift gehalten ist, wird die Gesamtanordnung, also die Federkontaktstiftanordnung, dadurch gehalten, dass die Montagehülse den Federkontaktstift hält und dass der Positionssensor, insbesondere der Positionssensorstift, über die Kupplungshülse an dem Federkontaktstift gehalten wird. Dieses gilt für die erwähnte Hintereinanderanordnung von Federkontaktstift und Positionssensor. Sind diese beiden Einheiten in Nebeneinanderanordnung zueinander angeordnet, so ist ein entsprechendes Kupplungselement vorgesehen, um die beiden Teile aneinander zu halten, wobei wiederum eine Montagehülse für den Federkontaktstift vorgesehen ist, um ihn an der Prüfeinrichtung zu halten und über das erwähnte Kupplungselement wird der Positionssensor, insbesondere Positionssensorstift, an dem Federkontaktstift gehalten.

Nach einer Weiterbildung der Erfindung ist vorgesehen, dass das Sensorelement mittels eines entgegen einer Verlagerungsrichtung wirkenden Federelements kraftbeaufschlagt ist und dadurch zur Verbindung von Kontaktelement und Sensorelement gegen das Kontaktelement gedrängt ist. Die erwähnte Verbindung zwischen Kontaktelement und Sensorelement wird in dem vorstehend beschriebenen Falle dadurch bewirkt, dass lediglich eine Anlage dieser beiden Teile erfolgt. Dies bedeutet, dass die beiden Teile vorzugsweise axial hintereinander angeordnet sind und dass eine Stirnfläche des Kontaktelements gegen eine Stirnfläche des Sensorelements anliegt, wobei die Anlage federbeaufschlagt erfolgt, derart, dass das Sensorelement mittels des Federelements gegen das Kontaktelement gedrängt wird. Das Kontaktelement selber ist hinsichtlich seiner längsverschieblichen Lagerung von der erwähnten Federeinrichtung beaufschlagt, sodass auch dieses stets in eine Grundstellung gedrängt wird. Daraus ergibt sich, dass die Federkonstanten der Federeinrichtung und des Federelements zusammenwirken, insbesondere additiv wirken.

Eine Weiterbildung der Erfindung sieht vor, dass Stiftgehäuse und Sensorgehäuse dieselben oder etwa dieselben Querschnittsabmessungen aufweisen. Dies ist besonders dann von Vorteil, wenn Federkontaktstift und Positionssensorstift in Hintereinanderanordnung zueinander angeordnet sind, da dann keiner der beiden Stifte einen wesentlich größeren Platz als der jeweils andere in Bezug auf die Querschnittsabmessung benötigt und insofern die höchstmögliche Anzahl von Federkontaktstiftanordnungen pro Prüffläche nicht durch einen der beiden Stifte besonders beschränkt wird.

Eine Weiterbildung der Erfindung sieht vor, dass der Positionssensor mindestens ein resistives, kapazitives, induktives, piezoelektrisches, piezoresistives, auf Schall, insbesondere Ultraschall, basierendes und/oder optisches Sensorglied aufweist, das vorzugsweise stufenlos arbeitet. Hierdurch ist die Abstands- und/oder Längenmessung ermöglicht. Das Sensorglied weist einen großen Messbereich (im Vergleich zu Schaltstiften) auf, welcher mindestens dem maximalen Kolbenhub des Federkontaktstifts entspricht. Durch das stufenlose Arbeiten ist eine kontinuierliche Messung und damit eine sehr genaue Positionsbestimmung (Längenmaßbestimmung) möglich, d.h., eine sehr hohe Präzision der Positionsmessung mit einer Auflösung von bis zu +/- 0,01 mm, wobei vorzugsweise ferner eine sehr hohe Reproduzierbarkeit der Positionsmessung von bis zu +/- 0,05 mm besteht. Die resistive Messung kann vorzugsweise über mindestens einen ohmschen Widerstand, beispielsweise ein Potentiometer erfolgen, dessen Widerstandswert in Abhängigkeit von der Stellung des Sensorelements eingestellt wird und die Stellung des Sensorelements von der Stellung des Kontaktelements abhängig ist. Auch die anderen Messmethoden (kapazitiv, induktiv und/oder optisch) ermöglichen eine hochgenaue, vorzugsweise stufenlose Messung der Position, wobei in jedem Falle durch eine entsprechende Auswertung des Messergebnisses auf eine geometrische Position "zurückgerechnet" werden kann.

Eine bevorzugte Ausführungsform der Erfindung sieht vor, dass der Positionssensor mindestens ein Potentiometer aufweist, das mindestens einen Schleifer und mindestens eine ohmsche Widerstandsbahn aufweist, und dass der Schleifer oder die ohmsche Widerstandsbahn mit dem Sensorelement gekuppelt ist. Über das Kontaktelement wird daher die Stellung des Sensorelements bestimmt, das zu einer entsprechenden Schleiferstellung oder Stellung der ohmschen Widerstandsbahn relativ zu einem feststehenden Schleifer führt, wodurch am Potentiometer ein entsprechender Widerstandswert und/oder - bei Beaufschlagung mit elektrischer Spannung - ein entsprechender Spannungswert abgegriffen werden kann, wobei das Messergebnis jeweils als Maß für eine hochgenaue Positionsbestimmung zur Verfügung steht.

Eine Weiterbildung der Erfindung sieht vor, dass der Positionssensor mit mindestens einer zweiten Schnittstelle der Federkontaktstiftanordnung in Verbindung steht. Die bereits erwähnte erste Schnittstelle ist der Funktion des Federkontaktstifts zugeordnet. Sie dient dazu von außen her eine elektrische Verbindung zum Kontaktelement zu schaffen, um eine entsprechende Messung am Prüfling vornehmen zu können. Die erwähnte zweite Schnittstelle ist dem Positionssensor zugeordnet, um das Messsignal des Sensorglieds von außen her abgreifen zu können.

Insbesondere kann die erste Schnittstelle und/oder die zweite Schnittstelle als mindestens eine kabelgebundene und/oder kabelungebundene Schnittstelle ausgebildet sein. Mindestens eine der Schnittstellen kann eine elektrische und/oder eine optische und/oder eine Funkverbindung zu einer Auswerteeinheit einer Prüfeinrichtung oder dergleichen schaffen. Sofern es sich bei der Schnittstelle um eine kabelgebundene Schnittstelle handelt, also ein Kabel angeschlossen wird, um elektrische Signale zu übertragen, kann eine Verbindungstechnik wie Crimpung, Wire Wrap, Festverkabelung, Steckkabelverbindung, Lötung, Schweißung und so weiter vorgesehen sein.

Besonders bevorzugt ist erfindungsgemäß vorgesehen, dass das Kontaktelement mit einem dem Kontaktbereich gegenüberliegenden Endbereich aus dem Stiftgehäuse herausragt, wobei der Endbereich mit dem Sensorelement in Verbindung steht. Das Kontaktelement nimmt somit mit einem Endbereich den Kontakt mit dem Prüfling vor, wobei es sich bei diesem Endbereich um den erwähnten Kontaktbereich handelt. Der andere Endbereich des Kontaktelements steht zur Übertragung des Hubs zum Positionssensor, insbesondere zum Positionssensorstift, zur Verfügung. Hierzu ist insbesondere vorgesehen, dass dieser Endbereich aus dem Stiftgehäuse herausragt und daher die Herausraglänge in Abhängigkeit vom Hub variiert. Der mit dem Federkontaktstift gekoppelte Positionssensor kann daher mit dem aus dem Stiftgehäuse herausragenden Endbereich beaufschlagt werden, mit der Folge, dass der Hub auf das Sensorelement des Positionssensors übertragen wird, das Sensorelement also denselben Hub durchläuft, und hierdurch die Positionsmessung, insbesondere Längenmessung, erfolgen kann. Kontaktelement kann auch ein Federkontaktstift-Kolben sein der standardmäßig bei bestimmten Stifttypen als durchgehender Kolben ausgeführt ist und ohnehin aus dem Stiftgehäuse gegenüberliegend zu dem Kontaktbereich herausragt.

Es ist vorteilhaft, wenn die erste und die zweite Schnittstelle am Positionssensor, insbesondere am Positionssensorstift, angeordnet sind. Grundsätzlich ist es denkbar, dass die erste Schnittstelle am Federkontaktstift und dass die zweite Schnittstelle am Positionssensor angeordnet ist, wobei bei einer Hintereinanderanordnung der beiden Einheiten die ersten Schnittstelle dann jedoch seitlich des Stiftgehäuses positioniert werden muss, was zu einer entsprechenden Querschnittsvergrößerung führt, die aufgrund einer möglichst hohen Packungsdichte nicht gewünscht ist. Befinden sich beide Schnittstellen am Positionssensor, so können diese im Bereich der hinteren Stirnfläche von diesem angeordnet werden, wodurch die Querschnittsabmessungen nicht beeinflusst werden und daher eine enge Anordnung von Federkontaktstiftanordnungen ermöglicht ist

Schließlich ist es vorteilhaft, wenn die erste und die zweite Schnittstelle die Querschnittsabmessungen von Stiftgehäuse und/oder Sensorgehäuse nicht überragen. Hierdurch können auf engem Raum, also mit kleinem Rastermaß, viele Federkontaktstiftanordnungen untergebracht und somit Prüflinge mit sehr eng liegenden Kontaktstellen einer Prüfung unterzogen werden.

Die Zeichnungen veranschaulichen die Erfindung anhand eines Ausführungsbeispiels und zwar zeigt.
- Figur 1: eine Seitenansicht - teilweise geschnitten - auf eine Federkontaktstiftanordnung mit Federkontaktstift, Positionssensor, der als Positionssensorstift ausgebildet ist, und Kupplungshülse,
- Figur 2: einen Längsschnitt durch die Anordnung der Figur 1 im zusammengefügten Zustand, wobei der Federkontaktstift nicht voller Länge dargestellt ist,
- Figur 3: einen Längsschnitt durch einen Abschnitt des Federkontaktstifts,
- Figur 4: einen Längsschnitt durch den Positionssensorstift,
- Figur 5: eine Stirnansicht auf die Rückseite des Positionssensors,
- Figur 6: einen Schnitt durch den Positionssensor entlang der Linie A-A der Figur 5,
- Figur 7: einen der Figur 6 entsprechender Längsschnitt durch den Positionssensor, jedoch um 90° verdreht,
- Figur 8: eine dreidimensionale, transparente Darstellung auf den Positionssensor, dessen Sensorelement keinen Hub aufweist und
- Figur 9: eine der Figur 8 entsprechende Darstellung, wobei das Sensorelement jedoch den Maximalhub durchlaufen hat.

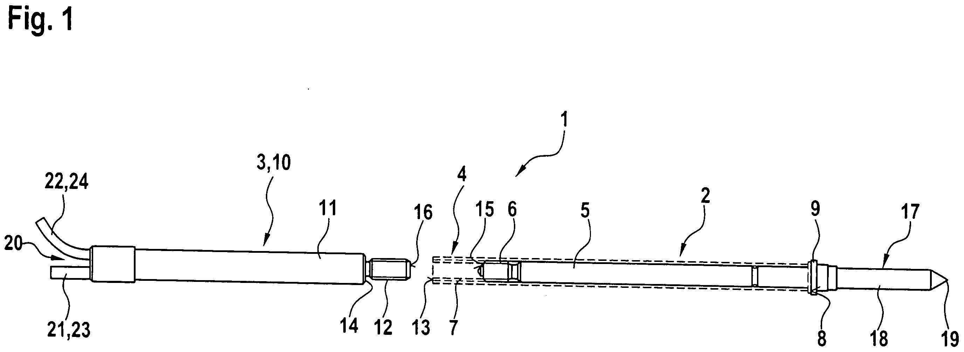

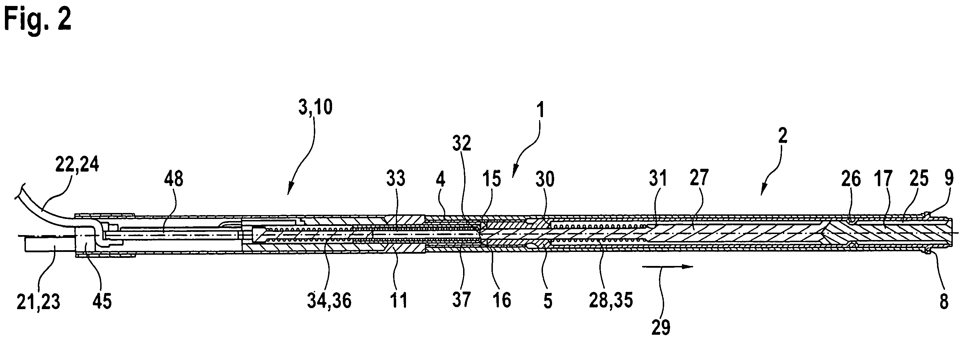

Die Figur 1 zeigt eine Federkontaktstiftanordnung 1, die einen Federkontaktstift 2, einen Positionssensor 3 und eine transparent dargestellte Kupplungshülse 4 aufweist. Der Federkontaktstift 2 befindet sich größtenteils innerhalb der Kupplungshülse 4; der Positionssensor 3 befindet sich in einer nicht mit der Kupplungshülse 4 verbundenen Stellung, d.h., in einer nicht montierten Position. Während des Betriebs, also dann, wenn mit der Federkontaktstiftanordnung 1 ein nicht dargestellter elektrischer Prüfling geprüft werden soll, ist der Federkontaktstift 2 mittels der Kupplungshülse 4 an einem Tragteil einer Prüfeinrichtung gehalten. Hierzu weist ein Stiftgehäuse 5 des Federkontaktstifts 2 ein Außengewinde 6 auf, das in ein Innengewinde 7 der Kupplungshülse 4 eingeschraubt ist. Das Einschrauben erfolgt soweit, bis eine Stirnfläche 8 der Kupplungshülse 4 gegen einen Flansch 9 des Stiftgehäuses 3 tritt. Der Positionssensor 3 ist - wie aus der Figur 1 ersichtlich - als Positionssensorstift 10 ausgebildet und besitzt ein Sensorgehäuse 11, das mit einem Außengewinde 12 versehen ist, das in das Innengewinde 7 der Kupplungshülse 4 derart weit eingeschraubt werden kann (vergleiche Figur 2), dass eine Stirnfläche 13 der Kupplungshülse 4 gegen eine Gehäusestufe 14 des Sensorgehäuses 11 tritt. Ist das Einschrauben erfolgt, so liegen sich die Stirnflächen 15 des Federkontaktstifts 2 und 16 des Positionssensors 3 mit geringem Abstand gegenüber, so wie dies der Figur 2 entnommen werden kann. Ein Kontaktelement 17 des Federkontaktstifts 2 ist längsverschieblich im Stiftgehäuse 5 gelagert und weist einen Kontaktbereich 18 auf, der axial aus dem Stiftgehäuse 2 herausragt. Der Kontaktbereich 18 kann mit einer Kontaktierspitze 19 versehen sein, die beim elektrischen Test eines elektrischen Prüflings (nicht dargestellt) auf eine Kontaktfläche von diesem aufgesetzt wird, sodass das Kontaktelement 17 mit entsprechend großem Hub in das Stiftgehäuse 5 einfedert. Stiftgehäuse 5 und Sensorgehäuse 11 sind vorzugsweise im Querschnitt kreisförmig ausgestaltet und weisen etwa dieselben Querschnittsabmessungen auf. Wie die Figur 2 zeigt, ist die Querschnittsabmessung des Positionssensorstifts 10 geringfügig größer als die Querschnittsabmessung des Federkontaktstifts 2. An einer Stirnseite 20 des Positionssensors 3 ist eine erste Schnittstelle 21 und eine zweite Schnittstelle 22 ausgebildet. Die erste Schnittstelle 21 ist als Lötfahne 23 ausgebildet. Die zweite Schnittstelle 22 wird von einer Kabelverbindung 24 gebildet, die vorzugsweise drei Kabel umfasst.

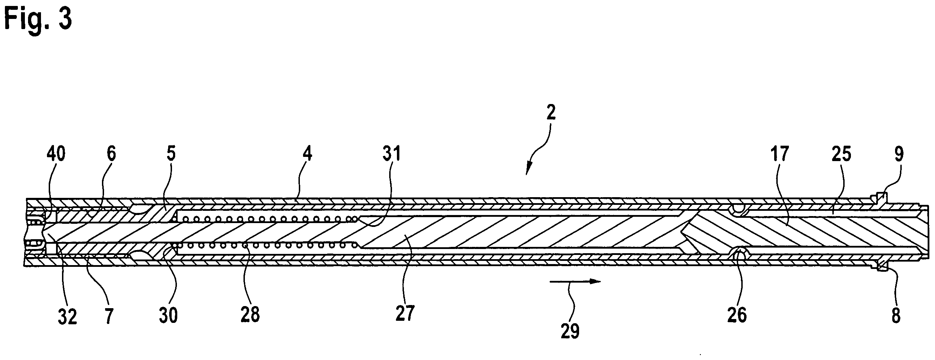

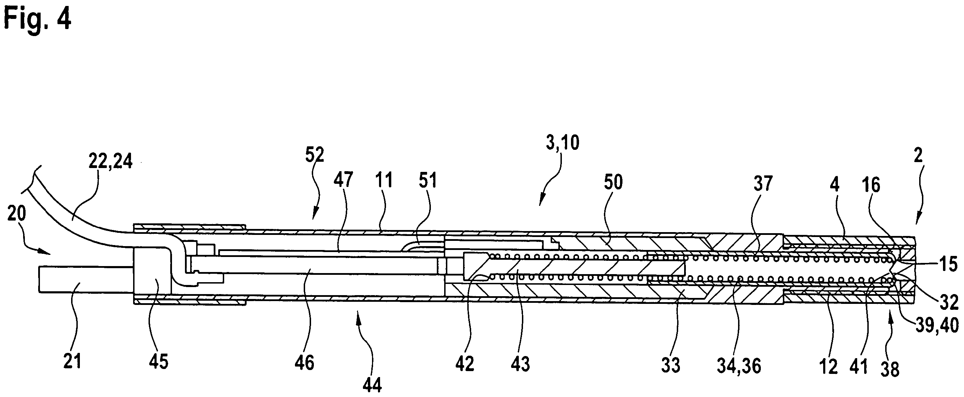

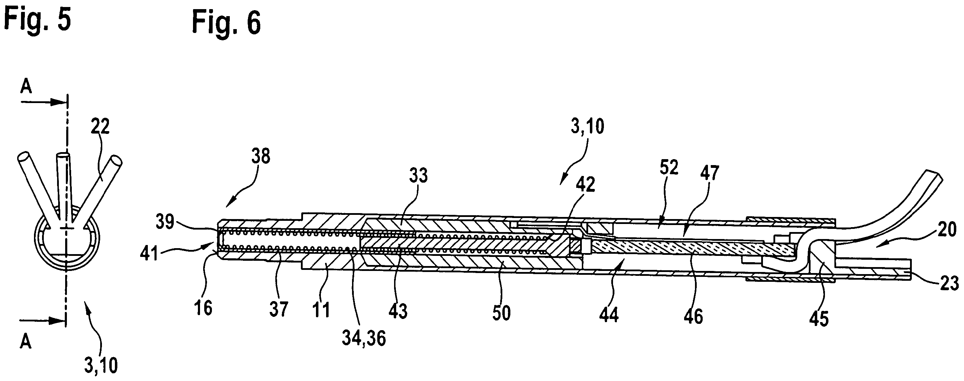

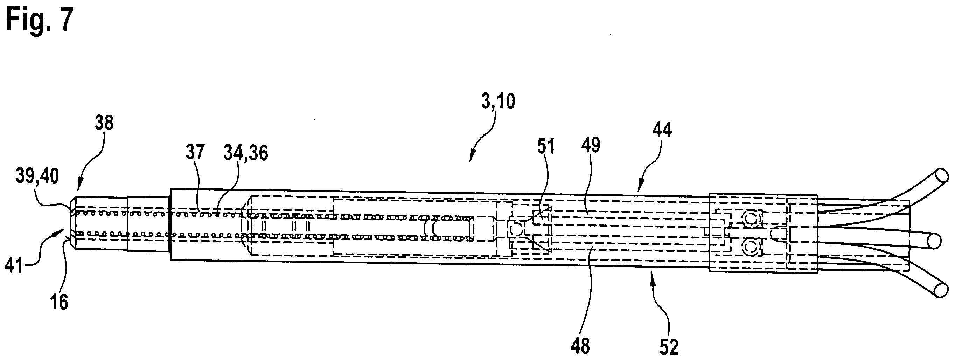

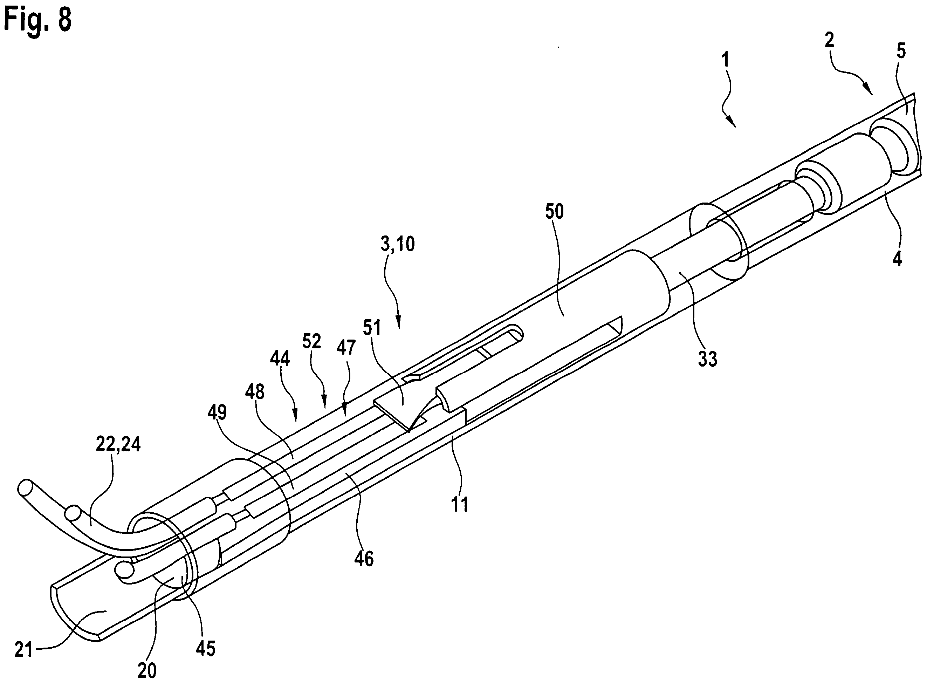

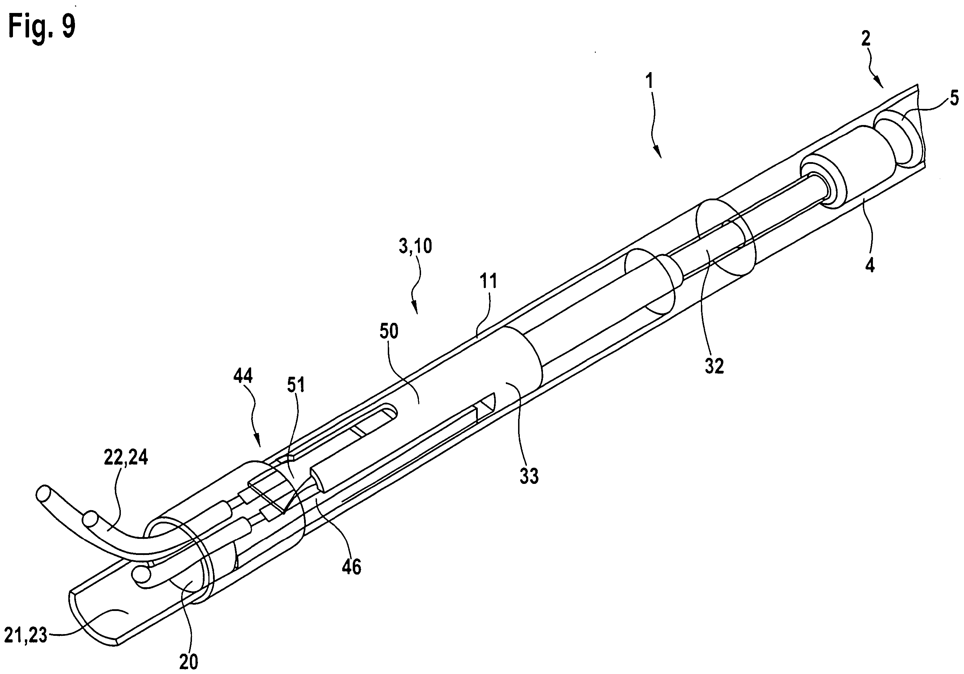

Die Figuren 2 bis 9 zeigen den inneren Aufbau der Federkontaktstiftanordnung 1. Es ist ersichtlich, dass das Kontaktelement 17 kolbenartig im Innern des Stiftgehäuses 5 geführt ist. Das Kontaktelement 17 weist eine Querschnittsverjüngung 25 auf, in die ein Vorsprung 26 des Stiftgehäuses 5 hineinragt, wodurch eine Hubbegrenzung gebildet ist, d.h., das kolbenartige Kontaktelement 17 kann axial nur einen bestimmten Hub durchlaufen.

Im Innern des Stiftgehäuses 5 ist ein Kolbenstößel 27 des Federkontaktstifts 2 axial verschieblich geführt, der einen Teil des Kontaktelements 17 bildet. Eine Federeinrichtung 35, die als Schraubendruckfeder 28 ausgebildet ist, stützt sich an einer Innenstufe 30 des Stiftgehäuses 5 und einer Stufe 31 des Kolbenstößels 27 ab und drängt daher das Kontaktelement 17 in Richtung des Pfeils 29. Im unbelasteten Zustand liegt - gemäß Figur 2 - das linksseitige Ende der Querschnittsverjüngung 25 am Vorsprung 26 an. Dies entspricht einem Hub des Kontaktelements 17 von "Null".

Die Figur 2 zeigt, dass im zusammengebauten Zustand von Federkontaktstift 2 und Positionssensorstift 10 die Stirnseiten 15 und 16 innerhalb der Kupplungshülse 4 einen geringen Abstand voneinander aufweisen. In der Stellung Hub = "Null" ragt das Kontaktelement 17 mit einem Endbereich 32 aus dem Stiftgehäuse 5 heraus und wird von einem Sensorelement 33 des Positionssensors 3 axial beaufschlagt, da das kolbenförmig ausgebildete Sensorelement 33 im Innern des Sensorgehäuses 11 axial verschieblich geführt ist und von einem Federelement 36, das als Schraubendruckfeder 34 ausgebildet ist, beaufschlagt wird. Das Sensorelement 33 weist ein Rohrstück 37 auf, das im Bereich seines Endes 38 eine Durchmesserverkleinerung in Form einer Einziehung 39 besitzt, die eine Abstützstufe 40 für das eine Ende der Schraubendruckfeder 34 bildet. Gegen den Rand einer verbleibenden Öffnung 41 tritt der vorzugsweise spitz zulaufende Endbereich 32 des Kolbenstößels 27 des Kontaktelements 17. Das andere Ende der Schraubendruckfeder 34 stützt sich an einer Stufe 42 eines Führungsglieds 43 ab, das zumindest ein stückweit in das Rohrstück 37 eingreift und zusammen mit einer Sensoreinheit 44 des Positionssensors 3 ortsfest innerhalb des Sensorgehäuses 11 angeordnet ist. Die Sensoreinheit 44 ist mittels eines Verschlussstücks 45 im Sensorgehäuse 11 gehalten und weist eine Platine 46 auf, auf der ein Sensorglied 47 in Form von zwei beabstandet parallel zueinander verlaufenden Bahnen 48, 49 angeordnet sind. Die Bahn 48 ist als ohmsche Widerstandsbahn und die Bahn 49 als elektrische Kollektorbahn ausgebildet.

Das Rohstück 37 ist fest mit einem gabelförmigen, im Innern des Sensorgehäuses 11 kolbenartig geführten Verlagerungsstück 50 verbunden, d.h., das Rohrstück 37 bildet zusammen mit dem Verlagerungsstück 50 ein Verschiebeteil, nämlich das Sensorelement 33, das innerhalb des Sensorgehäuses 11 entgegen der Kraft der Schraubendruckfeder 34 verlagerbar ist. An dem Verlagerungsstück 50 ist ein Schleifer 51 befestigt, der die beiden Bahnen 48 und 49 beaufschlagt und bei einer Verlagerung des Sensorelements 33 entlang der Bahnen 48 und 49 gleitet, sodass insgesamt ein Potentiometer 52 ausgebildet wird. Die erste Schnittstelle 21 ist als Gehäuseverlängerung (Lötfahne 23) des Sensorgehäuses 11 ausgebildet, wobei das Sensorgehäuse 11 aus elektrisch leitfähigem Material besteht und über die elektrisch leitfähige Kupplungshülse 4 sowie das elektrische leitfähige Stiftgehäuse 5 und das elektrisch leitfähige Kontaktelement 17 in elektrischer Verbindung mit dem Kontaktbereich 18 steht. Bei der Prüfung eines elektrischen Prüflings wird demzufolge ein elektrisches Potential des Prüflings über die erwähnten Bauteile bis zur ersten Schnittstelle 21 geleitet oder dem Prüfling auf diesem Wege zugeführt. Die zweite Schnittstelle 22, die drei Kabel der Kabelverbindung 24 betrifft, ist derart gestaltet, dass zwei der drei Kabel mit Enden der Bahnen 48 und 49 elektrisch verbunden sind. Das dritte Kabel führt über eine nicht ersichtliche Leiterbahn der Platine 46 bis zum anderen Ende der Bahn 48.

Es ergibt sich folgende Funktion: Es wird davon ausgegangen, dass die Federkontaktstiftanordnung 1 in eine Prüfeinrichtung eingebaut ist, mit der ein elektrischer Prüfling geprüft werden soll. Bei dem elektrischen Prüfling handelt es sich insbesondere um Kabelbäume, die mit Anschlüssen, beispielsweise Steckkontakten, ausgestattet sind. Für die Prüfung wird die Federkontaktstiftanordnung 1 mit dem Kontaktbereich 18 voran einem zu prüfenden Steckkontakt des Prüflings zugeführt. Vorzugsweise weist die Prüfeinrichtung eine Vielzahl von Federkontaktstiftanordnungen 1 auf, um mit einem Prüfungszyklus mehrere Prüfaufgaben parallel durchführen zu können. Die Prüfeinrichtung besitzt eine Aufnahme, an der die Kupplungshülse 4 festgelegt ist, in der der Federkontaktstift 2 und der Positionssensor 3 teilweise aufgenommen sind, so wie sich dies aus der Figur 2 ergibt. Es liegt demzufolge eine Hintereinanderanordnung von Federkontaktstift 2 und Positionssensor 3, insbesondere Positionssensorstift 10, vor. Wird nun für die Prüfung eine derartige Federkontaktstiftanordnung 1 in Richtung auf den Prüfling, zum Beispiel den erwähnten Steckkontakt, bewegt, so kontaktiert die Kontaktspitze 19 eine entsprechende Kontaktfläche des Steckkontakts. Durch die Aufeinanderzubewegung von Federkontaktstiftanordnung 1 und Prüfling 2 federt das Kontaktelement 17 ein stückweit entgegen der Kraft der Federeinrichtung 35 ein. Dieser Hub wird von dem Kontaktelement 17, nämlich dem zum Kontaktelement 17 gehörenden Kolbenstößel 27, auf das Sensorelement 33 des Positionssensors 3, insbesondere Positionssensorstifts 10, übertragen, wodurch dieses denselben Hub durchläuft, wie das Kontaktelement 17. Entsprechend dem durchlaufenden Hub wird die Sensoreinheit 44 angesteuert, nämlich im konkreten Fall der dargestellten Ausführungsform das Verlagerungsstück 50, wodurch sich die Bahnen 48 und 49 entlang des feststehenden Schleifers 51 bewegen. In Abhängigkeit des vollzogenen Einfederwegs, der eine Längenmessung ermöglicht, kann über die am Potentiometer 52 ermittelten Werte mittels einer Auswerteeinheit der Prüfeinrichtung festgestellt werden, ob sich das Kontaktelement im Steckkontakt des zu prüfenden Kabelbaums an der richtigen Position befindet, beispielsweise richtig in ein Isoliergehäuse eingerastet ist. Eine elektrische Prüfung der Kabelverbindung des Kabelbaums lässt sich demzufolge mit dem Federkontaktstift 2 durchführen, da dieser über sein Stiftgehäuse 5, das Sensorgehäuse 11 und die Schnittstelle 21 mit der Auswerteeinheit der Prüfeinrichtung in Verbindung steht (die Kabelverbindung von der ersten Schnittstelle 21 zur Auswerteeinheit ist nicht dargestellt). Insgesamt erfolgt daher eine gleichzeitige Doppelprüfung mittels der erfindungsgemäßen Federkontaktstiftanordnung 1, nämlich einerseits die Prüfung eines elektrischen Strompfads und andererseits eine Positionsprüfung des Prüflings.

In einem nicht dargestellten Ausführungsbeispiel kann vorgesehen sein, dass Federkontaktstift 2 und Positionssensor 3, insbesondere Positionssensorstift 10, nicht in Hintereinanderanordnung, sondern in Nebeneinanderanordnung zueinander angeordnet sind. Hierzu sind geeignete Verbindungsmittel vorgesehen, die die beiden Stifte in Parallelanordnung zueinander halten und es ist ein Übertragungsglied erforderlich, um die Einfederbewegung des Kontaktelements 17, also dessen Hub, auf das Sensorelement 33 zu übertragen, um entsprechende Daten über den Einfederweg von der Sensoreinheit 44 zu erhalten.

Beim dargestellten Ausführungsbeispiel sind die beiden Schnittstellen 21 und 22 als drahtgebundene Schnittstellen vorgesehen. Selbstverständlich sind auch andere Schnittstellenarten möglich, so beispielsweise über Funk, über Lichtwellenleiter und so weiter.

Nachfolgend wird die Erfindung sowie deren Vorteile nochmals kurz dargestellt. Das erfindungsgemäße Funktionsprinzip ermöglicht es sowohl eine elektrische Kontaktierung als auch gleichzeitig eine vorzugsweise stufenlos arbeitende Längenmessung, zum Beispiel mittels des erwähnten Potentiometers, vorzunehmen. Durch die Bauart des Positionssensors 3 in länglicher Form, insbesondere als Stiftelement, ist eine besonders platzsparende Lösung realisiert, die ein enges Rastermaß bei der Anordnung mehrerer Federkontaktstiftanordnungen 1 zulässt. Der Positionssensorstift 10 wird bevorzugt in axialer Anordnung zum Federkontaktstift 2 montiert, d.h., der Federkontaktstift 2 nimmt "rückseitig" den gleich ausgerichteten (nämlich axial ausgerichteten) Positionssensor 3 auf, sodass ein System: "Federkontaktstift mit integrierter Hubmessung" entsteht. Der modulare Aufbau der Federkontaktstiftanordnung 1, nämlich Federkontaktstift 2, Positionssensor 3, insbesondere Positionssensorstift 10, und Kupplungshülse 4 ist besonders flexibel und erlaubt es, verschiedene Federkontaktstifttypen einzusetzen, beispielsweise Verrastnadeln, Tellernadeln, steckbare Federkontaktstifte, schraubbare Federkontaktstifte, verdrehgesicherte Federkontaktstifte und so weiter, wobei die Federkontaktstifte 2 auch unterschiedliche Kopfformen, unterschiedliche Federkräfte, unterschiedliche Nennhübe und so weiter aufweisen können und beispielsweise stets mit ein und demselben oder mit verschiedenen Positionssensoren 3 kombinierbar sind.

Die schlanke Bauart ermöglicht es, ein enges Rastermaß mit einem lateralen Abstand bis hinab zu 100 mil zu realisieren. Das Koppeln des Kontaktelements 17 des Federkontaktstifts 2 mit dem Sensorelement 33 des Positionssensors 3 erfolgt vorzugsweise kraftschlüssig, insbesondere durch Anlage aneinander, wobei diese Anlage federkraftunterstützt ist. Durch diese Bauart und diese kraftschlüssige Verbindung kann beispielsweise der Federkontaktstift 2 sehr einfach ausgetauscht werden, indem er einfach aus der Kupplungshülse 4 herausgedreht wird. Der Positionssensor 3 muss dabei nicht verändert werden. Durch die erfindungsgemäße Bauart folgt das bewegliche Verschiebeteil, also insbesondere das Sensorelement 33 dem Kontaktelement 17 des Federkontaktstifts absolut synchron in beiden Verschieberichtungen.

Insbesondere ist vorgesehen, dass sowohl der Federkontaktstift 2 als auch der Positionssensor 3, insbesondere Positionssensorstift 10, mit einer Federanordnung (Federeinrichtung 35 sowie Federelement 36) versehen sind, wodurch der erwähnte Kraftschluss permanent zwischen den sich bewegenden Teilen erhalten bleibt und beide Federn zur Gesamtfederkraft des Systems, also der Federkontaktstiftanordnung 1, beitragen. Der Positionssensor 3 weist bevorzugt eine durchgängige elektrische Verbindung bis zum Kolben des Federkontaktstifts, also bis zum Kontaktbereich 18 des Kontaktelements 17 auf. Eine zugehörige Schnittstelle befindet sich am Sensorgehäuse 11. Der vorzugsweise elektrische Anschluss des Positionssensors 3, insbesondere die zweite Schnittstelle 22, ist galvanisch von der vorstehend erwähnten elektrischen Verbindung getrennt, sodass kein Signalübersprechen zwischen Positionsmessung und elektrischer Prüfung des Prüflings stattfinden kann.

Im Falle des erwähnten Potentiometers 52 wird mit Vorzug eine Drei-Leiter-Technik eingesetzt, um sowohl eine Widerstandsmessung als auch eine Spannungsmessung durchzuführen. Im Falle eines potentiometrischen Sensorprinzips (resistiv) ist prinzipbedingt eine strenge Linearität zwischen Wegstrecke und Sensorsignal gegeben. Vorzugsweise ist keine weiteren Signalverarbeitung notwendig, um einen Rückschluss auf den Hub zu erhalten.

Aufgrund des erfindungsgemäßen Sensorprinzips ist eine absolute als auch eine relative Positionsbestimmung in Einfederrichtung als auch in Ausfederrichtung möglich. Es ist ferner die Möglichkeit gegeben, beliebige Positionen des Prüflings zu "0" und von dort aus eine Absolut- oder Relativlage zu bestimmen. Ebenfalls lassen sich Toleranzen des Prüflings und/oder des gesamten Prüfaufbaus kompensieren, indem die Signale mehrerer Federkontaktstiftanordnungen 1 miteinander verrechnet werden (Differenzmessung). Auch gewollte oder ungewollte Bewegungen des Prüflings lassen sich detektieren. Das Sensorsignal des Positionssensors 3 kann sich vorzugsweise zur Positionsänderung linear verhalten, wie dies beispielsweise bei dem erwähnten Potentiometer 52 der Fall sein kann. Alternativ ist es natürlich auch möglich, nicht lineare Mittel einzusetzen oder nicht lineare Mittel zu linearisieren, was beispielsweise mittels geeigneter Signalverarbeitungsalgorithmen möglich ist. Das Sensorsignal kann entweder analoger oder digitaler Art sein. Bei Kenntnis der Federkennwerte der erfindungsgemäßen Federkontaktstiftanordnung 1 ist eine Ermittelung der Kontaktkraft auf den Prüfling möglich.

Die Erfindung betrifft als Federkontaktstift 1 auch den Einsatz eines sogenannten Schaltstifts, wodurch sich eine kontinuierliche Positionsmessung mit einer zusätzlichen Schaltschwelle verbinden lässt.

Durch die Kombination von Federkontaktstift 2 und Positionssensor 3 kann ein Anwender einen elektrischen Test des Prüflings ohne Einschränkungen durchführen und zusätzlich die Sensorsignale zur Positionsbestimmung der abgetasteten Bauteile des Prüflings auswerten. Die geschaffene Funktion ermöglicht zusätzlich zu elektrischen Merkmalen auch die Abfrage von geometrischen Merkmalen des Prüflings mit einer exzellenten Genauigkeit und Variabilität, und zwar insbesondere am gleichen Ort des Kontaktpunkts und zeitgleich mit der elektrischen Standardprüfung (die Standardprüfung erfolgt mit dem Federkontaktstift).

Im Vergleich zur bisherigen Technik (alleiniger Einsatz eines Schaltstifts), bietet die Erfindung einen extrem großen Messbereich für die Positionsbestimmung und ferner auch eine hochgenaue. Die Erfindung ermöglicht ferner eine Bestimmung der Absolutposition des Prüflings von relativ zur bisherigen Technik nahezu beliebig positionierten Prüflingen. Prüfposition und Toleranzbereich können innerhalb des Messbereichs elektronisch vorgegeben, variiert und nachgestellt werden, ohne in den Aufbau der Messanordnung eingreifen zu müssen. Es lassen sich Umgebungseinflüsse kompensieren, indem diese als Parameter mit dem Positionssensorsignal verrechnet werden.

Das erfindungsgemäße Prinzip mit der erfindungsgemäßen Federkontaktstiftanordnung 1 ist für die verschiedensten Anwendungen geeignet. Das erfindungsgemäße System kann insbesondere für den Test von Steckern beziehungsweise Kontaktelementen eingesetzt werden und es findet Anwendung bei Kabelbaumodulen zur Bestimmung/Prüfung von Fertigungsabweichungen, Steckerpinlängen, Bauteilversatz, Kammertiefen und so weiter. Ferner können mit der Erfindung bei Prüferadaptern oder anderen Prüfeinrichtungen Pinlängen- beziehungsweise generelle Längen- oder Tiefenabfragen neben den elektrischen Standardtests integriert werden.

## Patentansprüche

1. Federkontaktstiftanordnung (1) mit einem Federkontaktstift (2), der ein Stiftgehäuse (5) aufweist, in dem ein Kontaktelement (17) längsverschieblich gelagert und von einer entgegen einer Verschieberichtung wirkenden Federeinrichtung (35) kraftbeaufschlagt ist, wobei das Kontaktelement (17) mit mindestens einer ersten Schnittstelle (21) der Federkontaktstiftanordnung (1) in Verbindung steht und mit einem Kontaktbereich (18) zur elektrischen Kontaktierung eines elektrischen Prüflings aus dem Stiftgehäuse (5) herausragt, wobei die Federkontaktstiftanordnung (1) einen Positionssensor (3) aufweist, **dadurch gekennzeichnet, dass** das Kontaktelement (17) zur Übertragung seines Hubs mit einem verlagerbaren Sensorelement (33) des die Hubposition des Kontaktelements (17) erfassenden Positionssensors (3) in Verbindung steht, wobei das Sensorelement (33) denselben Hub durchläuft wie das Kontaktelement (17).

2. Federkontaktstiftanordnung nach Anspruch 1, **dadurch gekennzeichnet, dass** der Positionssensor (3) im Stiftgehäuse (5) des Federkontaktstifts (2) untergebracht ist oder als zum Federkontaktstift (2) separater Positionssensor (3), insbesondere Positionssensorstift (10), insbesondere mit einem stiftförmigen Sensorgehäuse (11), ausgebildet ist.

3. Federkontaktstiftanordnung nach einem der vorhergehenden Ansprüche, **dadurch gekennzeichnet, dass** Federkontaktstift (2) und Sensorelement (33), insbesondere Stiftgehäuse (5) und Sensorgehäuse (11), in Hintereinanderanordnung oder in Nebeneinanderanordnung zueinander angeordnet sind.

4. Federkontaktstiftanordnung nach einem der vorhergehenden Ansprüche, **gekennzeichnet durch** eine Kupplungshülse (4), die mit einem Bereich zumindest einen Abschnitt des Federkontaktstifts (2) und mit einem anderen Bereich zumindest einen Abschnitt des Positionssensors (3), insbesondere Positionssensorstifts (10), aufnimmt.

5. Federkontaktstiftanordnung nach einem der vorhergehenden Ansprüche, **dadurch gekennzeichnet, dass** die Kupplungshülse (4) eine Montagehülse des Federkontaktstifts (2) ist.

6. Federkontaktstiftanordnung nach einem der vorhergehenden Ansprüche, **dadurch gekennzeichnet, dass** das Sensorelement (33) mittels eines entgegen einer Verlagerungsrichtung wirkenden Federelements (36) kraftbeaufschlagt ist und dadurch zur Verbindung von Kontaktelement (17) und Sensorelement (33) gegen das Kontaktelement (17) gedrängt ist.

7. Federkontaktstiftanordnung nach einem der vorhergehenden Ansprüche, **dadurch gekennzeichnet, dass** Stiftgehäuse (5) und Sensorgehäuse (11) dieselben oder etwa dieselben Querschnittsabmessungen aufweisen.

8. Federkontaktstiftanordnung nach einem der vorhergehenden Ansprüche, **dadurch gekennzeichnet, dass** der Positionssensor (3) mindestens ein resistives, kapazitives, induktives, piezoelektrisches, piezoresistives, auf Schall, insbesondere Ultraschall, basierendes und/oder optisches Sensorglied (47) aufweist, das vorzugsweise stufenlos arbeitet.

9. Federkontaktstiftanordnung nach einem der vorhergehenden Ansprüche, **dadurch gekennzeichnet, dass** der Positionssensor (3) mit mindestens einer zweiten Schnittstelle (22) der Federkontaktstiftanordnung (1) in Verbindung steht.

10. Federkontaktstiftanordnung nach einem der vorhergehenden Ansprüche, **dadurch gekennzeichnet, dass** das Kontaktelement (17) mit einem dem Kontaktbereich (18) gegenüberliegenden Endbereich (32) aus dem Stiftgehäuse (5) herausragt, wobei der Endbereich (32) mit dem Sensorelement (33) in Verbindung steht.

11. Federkontaktstiftanordnung nach einem der vorhergehenden Ansprüche, **dadurch gekennzeichnet, dass** die erste Schnittstelle (21) und/oder die zweite Schnittstelle (22) als mindestens eine kabelgebundene und/oder kabelungebundene Schnittstelle ausgebildet ist.

12. Federkontaktstiftanordnung nach einem der vorhergehenden Ansprüche, **dadurch gekennzeichnet, dass** die erste und die zweite Schnittstelle (21,22) am Positionssensor (3), insbesondere am Positionssensorstift (10), angeordnet sind.

13. Federkontaktstiftanordnung nach einem der vorhergehenden Ansprüche, **dadurch gekennzeichnet, dass** die erste und die zweite Schnittstelle (21,22) die Querschnittsabmessungen von Stiftgehäuse (5) und/oder Sensorgehäuse (11) nicht überragen.

## Claims

1. Spring contact pin arrangement (1) with a spring contact pin (2) having a pin housing (5) in which a contact element (17) is mounted so as to be longitudinally displaceable and is force-actuated by a spring device (35) acting contrary to a displacement direction, wherein the contact element (17) is in contact with at least one first interface (21) of the spring contact pin arrangement (1) and protrudes from the pin housing (5) with a contact region (18) for making electrical contact with an electric test item, wherein the spring contact pin arrangement (1) comprises a position sensor (3), **characterised in that** the contact element (17), for transferring its stroke, is in contact with a displaceable sensor element (33) of the position sensor (3) detecting the stroke position of the contact element (17), wherein the sensor element (33) traverses the same stroke as the contact element (17).

2. Spring contact pin arrangement according to claim 1, **characterised in that** the position sensor (3) is accommodated in the pin housing (5) of the spring contact pin (2) or is configured as a position sensor (3), particularly a position sensor pin (10), particularly with a pin-shaped sensor housing (11), being separate from the spring contact pin (2).

3. Spring contact pin arrangement according to any one of the preceding claims, **characterised in that** spring contact pin (2) und sensor element (33), particularly pin housing (5) and sensor housing (11), are arranged behind one another or side by side.

4. Spring contact pin arrangement according to any one of the preceding claims, **characterised by** a coupling sleeve (4) which accommodates at least a portion of the spring contact pin (2) with one region and at least a portion of the position sensor (3), particularly the position sensor pin (10), with another region.

5. Spring contact pin arrangement according to any one of the preceding claims, **characterised in that** the coupling sleeve (4) is an assembly sleeve of the spring contact pin (2).

6. Spring contact pin arrangement according to any one of the preceding claims, **characterised in that** the sensor element (33) is force-actuated by means of a spring element (36) acting contrary to a displacement direction and thereby is pressed against the contact element (17) for connection of said contact element (17) and sensor element (33).

7. Spring contact pin arrangement according to any one of the preceding claims, **characterised in that** pin housing (5) and sensor housing (11) comprise identical or approximately identical cross-sectional dimensions.

8. Spring contact pin arrangement according to any one of the preceding claims, **characterised in that** the position sensor (3) has at least one resistive, capacitive, inductive, piezoelectric, piezoresistive, sound-based, particularly ultrasound-based, and/or optical sensor member (47) which functions preferably steplessly.

9. Spring contact pin arrangement according to any one of the preceding claims, **characterised in that** the position sensor (3) is in contact with at least a second interface (22) of the spring contact pin arrangement (1).

10. Spring contact pin arrangement according to any one of the preceding claims, **characterised in that** the contact element (17) protrudes from the pin housing (5) with an end region (32) opposing the contact region (18), wherein said end region (32) is in contact with the sensor element (33).

11. Spring contact pin arrangement according to any one of the preceding claims, **characterised in that** the first interface (21) and/or the second interface (22) is/are configured as at least a cable-connected and/or wireless interface.

12. Spring contact pin arrangement according to any one of the preceding claims, **characterised in that** the first and the second interface (21, 22) are arranged at the position sensor (3), particularly at the position sensor pin (10).

13. Spring contact pin arrangement according to any one of the preceding claims, **characterised in that** the first and the second interface (21, 22) do not protrude beyond the cross-sectional dimensions of pin housing (5) and/or sensor housing (11).

## Revendications

1. Agencement de tige de contact à ressort (1) comportant une tige de contact à ressort (2), laquelle présente un boîtier de tige (5) dans lequel un élément de contact (17) est monté de manière déplaçable longitudinalement et est soumis à une force par un dispositif à ressort (35) agissant en sens inverse d'un sens de déplacement, dans lequel l'élément de contact (17) est en liaison avec au moins une première interface (21) de l'agencement de tige de contact à ressort (1) et fait saillie hors du boîtier de tige (5) avec une zone de contact (18) destinée à la mise en contact électrique d'un échantillon électrique, l'agencement de tige de contact à ressort (1) présentant un capteur de position (3), **caractérisé en ce que** l'élément de contact (17), pour transmettre sa course, est en liaison avec un élément capteur (33) déplaçable du capteur de position (3) détectant la position de course de l'élément de contact (17), l'élément capteur (33) exécutant la même course que l'élément de contact (17).

2. Agencement de tige de contact à ressort selon la revendication 1, **caractérisé en ce que** le capteur de position (3) est logé dans le boîtier de tige (5) de la tige de contact à ressort (2) ou est réalisé comme capteur de position (3) séparé de la tige de contact à ressort (2), notamment comme tige de capteur de position (10), notamment avec un boîtier de capteur (11) en forme de tige.

3. Agencement de tige de contact à ressort selon l'une quelconque des revendications précédentes, **caractérisé en ce que** la tige de contact à ressort (2) et l'élément capteur (33), notamment le boîtier de tige (5) et le boîtier de capteur (11), sont disposés en disposition l'un derrière l'autre ou en disposition côte à côte l'un par rapport à l'autre.

4. Agencement de tige de contact à ressort selon l'une quelconque des revendications précédentes, **caractérisé par** une douille d'accouplement (4) qui, avec une zone, reçoit au moins une section de la tige de contact à ressort (2) et, avec une autre zone, reçoit au moins une section du capteur de position (3), notamment de la tige de capteur de position (10).

5. Agencement de tige de contact à ressort selon l'une quelconque des revendications précédentes, **caractérisé en ce que** la douille d'accouplement (4) est une douille de montage de la tige de contact à ressort (2).

6. Agencement de tige de contact à ressort selon l'une quelconque des revendications précédentes, **caractérisé en ce que** l'élément capteur (33) est soumis à une force au moyen d'un élément de ressort (36) agissant en sens inverse d'un sens de déplacement et est ainsi poussé contre l'élément de contact (17) pour relier l'élément de contact (17) et l'élément capteur (33).

7. Agencement de tige de contact à ressort selon l'une quelconque des revendications précédentes, **caractérisé en ce que** le boîtier de tige (5) et le boîtier de capteur (11) présentent les mêmes dimensions de section transversale ou environ les mêmes dimensions de section transversale.

8. Agencement de tige de contact à ressort selon l'une quelconque des revendications précédentes, **caractérisé en ce que** le capteur de position (3) présente au moins un élément de capteur (47) résistif, capacitif, inductif, piézoélectrique, piézorésistif, basé sur le son, notamment l'ultrason, et/ou optique, qui fonctionne de préférence de manière continue.

9. Agencement de tige de contact à ressort selon l'une quelconque des revendications précédentes, **caractérisé en ce que** le capteur de position (3) est en liaison avec au moins une deuxième interface (22) de l'agencement de tige de contact à ressort (1).

10. Agencement de tige de contact à ressort selon l'une quelconque des revendications précédentes, **caractérisé en ce que** l'élément de contact (17) fait saillie hors du boîtier de tige (5) avec une zone terminale (32) opposée à la zone de contact (18), la zone terminale (32) étant en liaison avec l'élément capteur (33).

11. Agencement de tige de contact à ressort selon l'une quelconque des revendications précédentes, **caractérisé en ce que** la première interface (21) et/ou la deuxième interface (22) sont réalisées comme au moins une interface filaire et/ou sans fil.

12. Agencement de tige de contact à ressort selon l'une quelconque des revendications précédentes, **caractérisé en ce que** la première et la deuxième interfaces (21, 22) sont disposées sur le capteur de position (3), notamment sur la tige de capteur de position (10).

13. Agencement de tige de contact à ressort selon l'une quelconque des revendications précédentes, **caractérisé en ce que** la première et la deuxième interfaces (21, 22) ne surmontent pas les dimensions de section transversale du boîtier de tige (5) et/ou du boîtier de capteur (11).
